# EUROPÄISCHE PATENTANMELDUNG

(11) **EP 0 765 030 A1**
(43) Veröffentlichungstag der Anmeldung: **26.03.1997**
(21) Anmeldenummer: 96202530.0
(22) Anmeldetag: 11.09.1996
(51) Int. Cl.: H03F 3/45

(54) **Schaltungsanordnung mit einem Differenzverstärker**

(30) Priorität: 20.09.1995 DE 19534873
(71) Anmelder: Philips Patentverwaltung GmbH, 22335 Hamburg (DE); Philips Electronics N.V., 5621 BA Eindhoven (NL)
(72) Erfinder: Wiese, Peter, 22335 Hamburg (DE); Biehl, Manfred, 22335 Hamburg (DE)
(74) Vertreter: Peters, Carl Heinrich, Dipl.-Ing.

(57) **Zusammenfassung**

Beschrieben wird eine Schaltungsanordnung mit einem Differenzverstärker mit zwei Ausgangsanschlüssen zum Abgeben zweier Ausgangssignale, die je einen im Gegentakt zueinander um einen Bezugspegel variablen Signalanteil (Gegentaktsignal) aufweisen.

In dieser Schaltungsanordnung wird eine deutliche Verbesserung der Gleichtaktunterdrückung erreicht durch eine Regelungsschaltung, die eingerichtet ist
- zum Bilden eines Summensignals aus den Ausgangssignalen,
- zum Bilden eines Differenzsignals aus dem Summensignal und einem Referenzsignal sowie
- zum Steuern des Bezugspegels beider Gegentaktsignale nach Maßgabe des Differenzsignals.

## Beschreibung

Die Erfindung bezieht sich auf eine Schaltungsanordnung, enthaltend einen Differenzverstärker mit zwei Ausgangsanschlüssen zum Abgeben zweier Ausgangssignale, die je einen im Gegentakt zueinander um einen Bezugspegel variablen Signalanteil (Gegentaktsignal) aufweisen.

Differenzverstärker werden bevorzugt zum Übertragen und Verstärken von Gegentaktsignalen bei gleichzeitiger Unterdrückung von Gleichtaktsignalen verwendet. Bei herkömmlichen Differenzverstärkern wird - auch in der integrierten Schaltungstechnik - eine hohe Gleichtaktunterdrückung durch bestmöglich gleiche Strukturen, d.h. Kenndaten der verwendeten Bauelemente, erreicht. Dazu dienen insbesondere ein symmetrischer Aufbau des Differenzverstärkers und geringe Abstände seiner Bauelemente.

Es zeigt sich jedoch, daß gerade bei Herstellung von Differenzverstärkern in integrierter Schaltungstechnik die erreichbaren Fertigungstoleranzen nicht genügen, um eine für bestimmte Anwendungen zu fordernde, hohe Gleichtaktunterdrückung zu gewährleisten.

Die Erfindung hat die Aufgabe eine Schaltungsanordnung der eingangs genannten Art mit einer verbesserten Gleichtaktunterdrückung zu schaffen.

Diese Aufgabe wird erfindungsgemäß bei einer Schaltungsanordnung der gattungsgemäßen Art gelöst durch eine Regelungsschaltung, die eingerichtet ist
- zum Bilden eines Summensignals aus den Ausgangssignalen,
- zum Bilden eines Differenzsignals aus dem Summensignal und einem Referenzsignal sowie
- zum Steuern des Bezugspegels beider Gegentaktsignale nach Maßgabe des Differenzsignals.

Bei dieser Regelungsschaltung wird durch die Summation der Ausgangssignale des Differerzverstärkers zur Regelung nur ein in den Ausgangssignalen enthaltenes Gleichtaktsignal ausgenutzt. Dieses Summensignal wird mit dem Referenzsignal verglichen; aus diesem Vergleich wird der Bezugspegel nachgesteuert, bis das Gleichtaktsignal vollständig ausgeregelt ist. Damit läßt sich in einfacher Weise eine bedeutende Verbesserung der Gleichtaktunterdrückung erzielen.

Die Unteransprüche stellen vorteilhafte Weiterbildungen der erfindungsgemäßen Schaltungsanordnung dar.

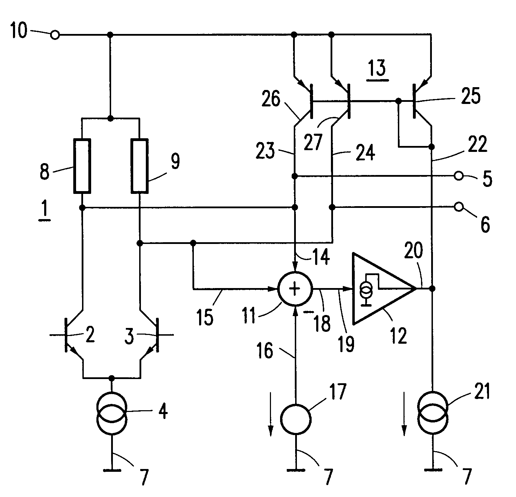

Ein Ausführungsbeispiel ist in der Figur wiedergegeben und wird im nachfolgenden näher erläutert.

Es zeigt einen ein Transistorenpaar 2, 3 aus bipolaren Transistoren enthaltenden Differenzverstärker 1, bei dem die Kollektoranschlüsse der bipolaren Transistoren 2 und 3 zwei Ausgangsanschlüsse 5 bzw. 6 zum Abgeben zweier Ausgangssignale bilden. Emitterseitig sind die Transistoren 2 und 3 mit einer gemeinsamen Speisestromquelle 4 verbunden, die andererseits an Masse 7 geführt ist. Somit sind die Hauptstrompfade der Transistoren 2, 3 mit der Speisestromquelle 4 verbunden. Mit den Kollektoranschlüssen der Transistoren 2, 3 sind Arbeitswiderstände 8 bzw. 9 verbunden, die andererseits gemeinsam mit einem Versorgungsspannungsanschluß 10 verbunden sind und von denen somit je einer mit jedem der Hauptstrompfade in Reihe angeordnet ist. Die Verbindungspunkte der Arbeitswiderstände 8, 9 mit den Transistoren 2 bzw. 3 bilden dabei die Ausgangsanschlüsse 5 bzw. 6.

Das in der Figur dargestellte Ausführungsbeispiel umfaßt weiterhin eine Regelungsschaltung mit einer Additionsstufe 11, einer Transkonduktorstufe 12 und einer Steuerstromübertragungsschaltung 13. Die Additionsstufe weist einen ersten Eingang 14 auf, der mit dem ersten Ausgangsanschluß 5 des Differenzverstärkers 1 verbunden ist. Ein zweiter Eingang 15 der Additionsstufe 11 ist mit dem zweiten Ausgangsanschluß 6 des Differenzverstärkers 1 verbunden, und an einen dritten Eingang 16 ist ein Anschluß einer im übrigen mit Masse 7 verbundenen Referenzsignalquelle 17 geführt. Diese gibt bevorzugt eine Gleichspannung als Referenzsignal ab. Der erste und der zweite Eingang 14, 15 der Additionsstufe 11 sind als Additionseingänge, der dritte Eingang 16 ist als Subtraktionseingang ausgeführt. Demgemäß werden in der Additionsstufe die Ausgangssignale des Differenzverstärkers 1 additiv mit dem negativen Wert des Referenzsignals von der Referenzsignalquelle 17 überlagert. Diese Überlagerung bildet ein Differenzsignal, welches an einem Ausgang 18 der Additionsstufe 11 abgegeben werden kann.

Die Additionsstufe 11 kann in an sich bekannter Weise mit einem ohmschen Widerstandsnetzwerk ausgebildet sein. Beispielweise kann dieses ohmsche Widerstandsnetzwerk mit einem Operationsverstärker zu einer analogen Rechenschaltung ausgestaltet sein, wie diese beispielsweise in Tietze/Schenk, "Halbleiter-Schaltungstechnik", 8. Auflage, 1986, Seiten 299 ff, dargestellt sind.

Der Ausgang 18 der Additionsstufe 11 ist mit einem Eingang 19 der Transkonduktorstufe 12 verbunden. In der Transkonduktorstufe wird die dem Eingang 19 zugeführte Spannung in einen ihr proportionalen Strom umgewandelt, der an einem Ausgang 20 der Transkonduktorstufe 12 abgegeben wird. Auch derartige Transkonduktorstufen sind als gesteuerte Stromquellen, beispielsweise als Operationsverstärker mit Stromausgang, im Prinzip bekannt.

Der Ausgang 20 der Transkonduktorstufe 12 ist gemeinsam mit einem Anschluß einer andererseits mit Masse 7 verbundenen Konstantstromquelle 21 an einen Eingang 22 der Steuerstromübertragungsschaltung 13 angeschlossen, deren Ausgänge 23 bzw. 24 mit den Ausgangsanschlüssen 5 bzw. 6 verbunden sind. Die Steuerstromübertragungsschaltung 13 ist mit einer Stromspiegelanordnung ausgebildet, die einen Eingangszweig mit einem als Diode geschalteten und mit dem Eingang 22 verbundenen pnp-Transistor 25 und je einen Ausgangszweig zu jedem der Ausgangsanschlüsse 5 bzw. 6 des Differenzverstärkers 1 mit je einem pnp-Transistor 26 bzw. 27 umfaßt, wobei die Basisanschlüsse der pnp-Transistoren 25, 26, 27 miteinander verbunden sind. Der pnp-Transistor 26 des Ausgangszweigs zu dem Ausgangsanschluß 5 ist mit dem Ausgang 23 der Steuerstromübertragungsschaltung 13, der pnp-Transistor 27 des Ausgangszweigs zum Ausgangsanschluß 6 mit deren Ausgang 24 verbunden.

In der beschriebenen Schaltungsanordnung werden somit die Ausgangssignale des Differenzverstärkers 1 in der Additionsstufe summiert und von dem so gebildeten Summersignal das Referenzsignal von der Referenzsignalquelle 17 subtrahiert. Dadurch wird ein Differenzsignal gebildet, aus welchem die Gegentaktsignale, d.h. die im Gegentakt zueinander um den Bezugspegel variierenden Signalanteile in den Ausgangssignalen eliminiert sind und das somit nur noch das Gleichtaktausgangssignal des Differenzverstärkers 1 darstellt. Dieses Gleichtaktausgangssignal wird in der Transkonduktorstufe 12 in einen dazu proportionalen ersten Steuerstrom umgewandelt. Zusammen mit dem Konstantstrom der Konstantstromquelle 21, durch den eine Arbeitspunkteinstellung der Regelschaltung ermöglicht wird, wird der erste Steuerstrom der Stromspiegelanordnung in der Steuerstromübertragungsschaltung 13 zugeleitet. Aus dem ersten Steuerstrom (und dem Konstantstrom) abgeleitete (zweite und dritte) Steuerströme werden dann in die Ausgangsanschlüsse 5 bzw. 6 des Differenzverstärkers 1 eingespeist. Dadurch wird die Aufteilung des von der Speisestromquelle 4 an die Transistoren 2, 3 gelieferten Stromes in einerseits die Arbeitswiderstände 8 bzw. 9 und andererseits die Steuerstromübertragungsschaltung 13 verändert, wodurch das Ausgangspotential (Bezugspotential) des Differenz verstärkers 1 nachgeregelt wird, bis das Gleichtaktsignal an den Ausgangsan schlüssen 5, 6 des Differenzverstärkers 1 verschwunden ist.

Auf diese Weise ist eine sehr große Verbesserung der Gleichtaktunterdrückung mit einer einfach aufzubauenden Schaltung möglich. In einem Anwendungsfall war die Gleichtaktunterdrückung eines konventionell aufgebauten CI-Mischers mit ca. 36 dB zu niedrig. Eine sinusförmige Störung auf der Betriebsspannung bildete sich als Gleichtaktsignal auf den Ausgängen des CI-Mischers ab. Durch die unzureichende Gleichtaktunterdrückung der konventionellen Schaltung wurde dieses Störsignal in eine differentielle Form umgewandelt und als Gegentakt-Störsignal weitergeleitet. Dadurch wurde die Funktion des Gesamtsystems stark beeinträchtigt. Mit der erfindungsgemäßen Ausbildung der Schaltungsanordnung ist es ohne weiteres möglich, in diesem konkreten Fall die geforderte Gleichtaktunterdrückung von 50 dB zu erreichen.

## Patentansprüche

1. Schaltungsanordnung, enthaltend einen Differenzverstärker mit zwei Ausgangsanschlüssen zum Abgeben zweier Ausgangssignale, die je einen im Gegentakt zueinander um einen Bezugspegel variablen Signalanteil (Gegentaktsignal) aufweisen,
gekennzeichnet durch
eine Regelungsschaltung, die eingerichtet ist
- zum Bilden eines Summensignals aus den Ausgangssignalen,
- zum Bilden eines Differenzsignals aus dem Summensignal und einem Referenzsignal sowie
- zum Steuern des Bezugspegels beider Gegentaktsignale nach Maßgabe des Differenzsignals.

2. Schaltungsanordnung nach Anspruch 1, dadurch gekennzeichnet,
daß die Regelungsschaltung umfaßt:
- eine Additionsstufe zum additiven Überlagern der Ausgangssignale mit dem Negativen des Referenzsignals und Abgeben des demgemäßen Differenzsignals,
- eine Transkonduktorstufe zum Liefern eines ersten Steuerstroms entsprechend dem Differenzsignal und
- eine Steuerstromübertragungsschaltung zum Einspeisen eines zweiten bzw. dritten Steuerstroms in je einen Ausgangsanschluß des Differenzverstärkers, wodurch der Bezugspegel der Ausgangssignale des Differenzverstärkers entsprechend dem ersten Steuerstrom einstellbar ist.

3. Schaltungsanordnung nach Anspruch 2, dadurch gekennzeichnet,
daß die Steuerstromübertragungsschaltung eine Stromspiegelanordnung mit einem Eingangszweig für den ersten Steuerstrom und je einem Ausgangszweig für den zweiten bzw. dritten Steuerstrom umfaßt.

4. Schaltungsanordnung nach Anspruch 2 oder 3, dadurch gekennzeichnet,
daß der Differenzverstärker umfaßt:
- ein Transistorenpaar mit einseitig miteinander und mit einer gemeinsamen Speisestromquelle verbundenen Hauptstrompfaden,
- je einen Arbeitswiderstand in Reihe mit jedem Hauptstrompfad, wobei die Verbindungspunkte der Arbeitswiderstände mit den Transistoren die Ausgangsanschlüsse bilden.

5. Schaltungsanordnung nach Anspruch 2, 3 oder 4, gekennzeichnet durch eine Konstantstromquelle zum Überlagern eines Konstantstromes mit dem ersten Steuerstrom.

6. Schaltungsanordnung nach Anspruch 2, 3, 4 oder 5, dadurch gekennzeichnet, daß die Additionsstufe mit einem ohmschen Widerstandsnetzwerk ausgebildet ist.
